Europäisches Patentamt

European Patent Office

Office européen des brevets

(11) Veröffentlichungsnummer: **0 406 641 A1**

## (12) EUROPÄISCHE PATENTANMELDUNG

(21) Anmeldenummer: 90111852.1

(22) Anmeldetag: 22.06.90

(51) Int. Cl.5: **C23C 14/04, C23C 14/56**

(30) Priorität: 06.07.89 DE 3922187

(43) Veröffentlichungstag der Anmeldung:
09.01.91 Patentblatt 91/02

(84) Benannte Vertragsstaaten:
**BE DE FR GB IT**

(71) Anmelder: **LEYBOLD AKTIENGESELLSCHAFT**
**Wilhelm-Rohn-Strasse 25**
**D-6450 Hanau am Main 1(DE)**

(72) Erfinder: **Heinz, Jochen**

Albert-Schweitzer-Strasse 5
D-6307 Linden(DE)
Erfinder: **Krug, Thomas, Dr.**
Hirschstrasse 19
D-6450 Hanau 1(DE)
Erfinder: **Rübsam, Klemens**
Schulstrasse 16
D-6485 Jossgrund 1(DE)
Erfinder: **Kessler, Hans**
Brahmsweg 2
D-6450 Hanau 1(DE)

(54) **Vorrichtung zum Herstellen von metallfreien Streifen bei im Vakuum beschichteten Folienbahnen, insbesondere für Kondensatoren.**

(57) Bei einer Vorrichtung zum Herstellen von metallfreien Streifen bei im Vakuum beschichteten Folienbahnen, insbesondere für Kondensatoren, bestehend aus einem Gehäuse, mit einem Deckel zum druckdichten Verschließen des Gehäuses und einer Wickeleinrichtung, mit zwischen Platinen drehbar gelagerten Umlenk- und Spannrollen, mindestens einer Beschichtungsrolle und einer Aufwickel-und Abwickelrolle sowie einer im Gehäuse gehaltenen Beschichtungsquelle und mit einem quer zur Laufrichtung der Wickelbahn angeordneten, vorzugsweise rohrförmigen Gefäß (34) zur Aufnahme von einem verdampfbaren Trennmittel (33), beispielsweise von einem Öl, mit mindestens einer Düse (36) für den Austritt des zu verdampfenden Trennmittels (33) aus dem Gefäß (34) auf die in unmittelbarer Nachbarschaft der Austrittsdüse (36) vorbeilaufende Folienbahn (50) ist das zumindest teilweise mit einem verdampfbaren Trennmittelvorrat (33) gefüllte Gefäß (34) mit mindestens einem Dampfaustrittsrohr (39) versehen ist, dessen Austrittsdüse (36) unterhalb des Oberflächenniveaus (46) des Trennmittelvorrats (33) in die Beschichtungskammer in unmittelbarer Nähe der zu beschichtenden Folienbahn (50) mündet, wobei das der Düse (36) abgekehrte Ende des Dampfaustrittsrohrs (39) im Raum (40) des Gefäßes (34) oberhalb des Trennmittelvorrats (33) endet.

FIG.3

# VORRICHTUNG ZUM HERSTELLEN VON METALLFREIEN STREIFEN BEI IM VAKUUM BESCHICHTETEN FOLIENBAHNEN, INSBESONDERE FÜR KONDENSATOREN

Die Erfindung betrifft eine Vorrichtung zum Herstellen von metallfreien Streifen bei im Vakuum beschichteten Folienbahnen, insbesondere für Kondensatoren, bestehend aus einem Gehäuse, mit einem Deckel zum druckdichten Verschließen des Gehäuses und einer Wickeleinrichtung mit zwischen Platinen drehbar gelagerten Umlenk- und Spannrollen, mindestens einer Beschichtungsrolle und einer Aufwickel- und Abwickelrolle sowie einer im Gehäuse gehaltenen Beschichtungsquelle und mit einem quer zur Laufrichtung der Wickelbahn angeordneten, vorzugsweise rohrförmigen Gefäß zur Aufnahme von einem verdampfbaren Trennmittel, beispielsweise von einem Öl, mit mindestens einer Düse für den Austritt des zu verdampfenden Trennmittels aus dem Gefäß auf die in unmittelbarer Nachbarschaft der Austrittsdüse vorbeilaufende Wickelbahn.

Bekannt ist ein Verfahren zur Herstellung von metallfreien Streifen bei der Metallbedampfung eines Isolierstoffbandes (DE-PS 32 24 234, DAS 26 52 438), das für den Einsatz in elektrischen Kondensatoren bestimmt ist, bei dem das Isolierstoffband im Bereich der herzustellenden metallfreien Streifen durch ein endloses, am Isolierstoffband anliegendes und mit gleicher Geschwindigkeit mit diesem mitlaufenden Abdeckband abgedeckt wird, das vor dem Einlaufen in die Bedampfungszone auf der dem Metallbedampfer zugewandten Seite mit Öl beschichtet wird und das nach dem Durchlaufen der Bedampfungszone und nach dem Auseinanderführen des Abdeckbandes und des Isolierstoffbandes vom aufgedampften Metall durch Abstreifen befreit wird, wozu zunächst das zu metallisierende Isolierstoffband und das Abdeckband zusammen in Kontakt gebracht werden, wobei dann durch Aufdampfen von Öl ein Film hergestellt wird, der auf die seitlichen Flächen des Abdeckbandes sowie geringfügig auch angrenzende Flächenbereiche des Isolierstoffbandes bedeckt, wonach mit Metall bedampft wird.

Weiterhin ist eine Vorrichtung zum gleichzeitigen Aufdampfen von mehreren parallelen Streifen aus flüssigen oder fettartigen Stoffen mit niedrigem Dampfdruck, vorzugsweise öligen Substanzen, auf insbesondere für die Herstellung elektrischer Kondensatoren bestimmten Bändern als Abdeckmittel für eine nachfolgende Metallbedampfung bekannt (DE-PS 1 262 732), bestehend aus einem mit einer Heizwicklung umwickelten Verdampfergefäß, das mehrere von einem Vorratsgefäß gespeiste Verdampferdüsen aufweist, wobei ein rohrförmiges Verdampfergefäß, das mit einer dem Abstand und der Breite der herzustellenden Abdeckstreifen entsprechend angeordneten Anzahl von Düsen versehen ist und das einen Einfüllstutzen besitzt, versehen ist.

Schließlich ist ein Verfahren zum fortlaufenden Abbrennen von schmalen Streifen aus einer auf einem insbesondere bandförmigen Dielektrikum eines elektrischen Kondensators aufgebrachten, insbesondere aufgedampften, dünnen Metallbelegung mittels radförmiger Abbrennelektroden bekannt (DE-PS 1 127 474), bei dem zwei Abbrennräder, zwischen denen eine Brennspannungsquelle ( +, -) liegt, mit geringem Abstand nebeneinander auf der Schicht entlanggeführt, die Schichtteile zwischen den Aufsetzstellen der Räder weggebrannt werden und der Abbrand fortlaufend entfernt wird.

Der vorliegenden Erfindung liegt nun die Aufgabe zugrunde, eine Vorrichtung zum Aufbringen von Trennmittel so auszubilden, daß sie auch bei Beschichtungsanlagen einsetzbar ist, bei denen die Austrittsrichtung des Dampfstrahls lotrecht nach unten oder schräg nach unten erfolgt und bei der eine Betriebsstörungen verursachende Kondensation von Trennmittel im Bereich der Düse nicht erfolgen kann.

Erfindungsgemäß wird diese Aufgabe dadurch gelöst, daß das zumindest teilweise mit dem verdampfbaren Trennmittel gefüllte Verdampfergefäß mit einem Dampfaustrittsrohr versehen ist, dessen Austrittsdüse unterhalb des Oberflächenniveaus des Trennmittelvorrats in die Kammer in unmittelbarer Nähe der zu beschichtenden Folienbahn mündet, wobei das der Düse abgekehrte Ende des Dampfaustrittsrohrs im Raum oberhalb des Trennmittelvorrats endet.

Weitere Merkmale und Einzelheiten sind in den Patentansprüchen näher gekennzeichnet.

Die Erfindung läßt die verschiedensten Ausführungsmöglichkeiten zu; eine davon ist in den anhängenden Zeichnungen rein schematisch dargestellt, und zwar zeigen:

Fig. 1 die Draufsicht auf einen Teil einer Bandbeschichtungsanlage, deren Wickelvorrichtung für den Ladevorgang aus der als Hohlzylinder ausgebildeten Beschichtungskammer herausgefahren ist, wobei einige der in Figur 2 dargestellten Umlenk- und Spannrollen der bessseren Übersichtlichkeit wegen nicht näher dargestellt sind,

Fig. 2 die Seitenansicht der Anlage, und zwar im Schnitt gemäß den Linien A - B nach Figur 1, und

Fig. 3 einen Schnitt quer durch das rohrförmige Gefäß zum Verdampfen des Trennmittels in vergrößerter Darstellung

Die Bandbeschichtungsanlage besteht im wesentlichen aus den zwischen zwei Platinen 2, 4 gelagerten Umlenk-, Zugmeß-, Streck- und Spannrollen 5 bis 17 bzw. der gekühlten Beschichtungswalze 18, der Abwickelrolle 37' und der Aufwickelrolle 35', der in der von einem Hohlzylinder 32 gebildeten Beschichtungskammer 28 angeordneten Verdampfungsquelle 19 mit Aluminiumdrahtspule 20 und dem Verdampfungsschiffchen 21 sowie einer Fernsehkamera 22 zur Beobachtung des Beschichtungsprozesses. Die beiden am Stützgestell 52 befestigten Platinen 3, 4 können über Rollen 26, 27 auf Laufschienen 24, 25, zusammen mit den Rollen 5 bis 17 und der Beschichtungswalze 18, die die Wickeleinrichtung 29 bilden, in Pfeilrichtung R in die Beschichtungskammer 28 hinein bzw. aus dieser herausgefahren werden. Bei eingefahrener Wickeleinrichtung 29 legt sich der am Stützgestell 52 fest angeordnete scheibenförmige Deckel 30 mit seiner Randpartie gegen die flanschförmige Stirnfläche 31 des Hohlzylinders 32 und wird dort von nicht näher dargestellten Klammern am Hohlzylinder 32 fixiert bzw. durch den während der Betriebsphase in der Kammer 45 herrschenden Unterdruck vom Atmosphärendruck gegen die Stirnfläche 31 gezogen.

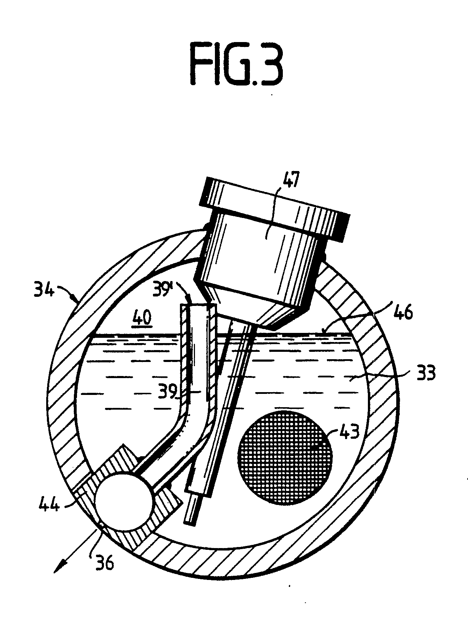

Das in Figur 3 dargestellte Verdampfergefäß 34 ist aus einem Rohrstück gebildet, dessen beide Enden durch kreisscheibenförmige Endteile verschlossen sind. Im Inneren des Gefäßes 34 ist ein stabförmiges Heizelement 43 angeordnet, das vom Trennmittel 33 vollständig umspült ist und das sich nahe einem Dampfaustrittsrohr 39 befindet, das in etwa lotrechter Stellung an der Bodenpartie des Gefäßes 34 gehalten ist. Das Dampfaustrittsrohr 39 ist dazu mit seinem Düsenkopf 44 mit der Wandung des Gefäßes 34 verlötet oder verschweißt, wobei die Länge des Dampfaustrittsrohrs 39 so bemessen ist, daß das obere Ende 39' des Rohres 39 oberhalb des Badspiegels 46 des Trennmittels 33 in den Raum 40 einmündet.

Zweckmäßigerweise ist das Gefäß 34 noch mit einem Temperaturfühler 47 ausgestattet, der eine genaue Überwachung und Einhaltung der Trennmittelbadtemperatur gestattet (der für die Überwachung und Regelung des Heizkreises notwendige Schaltkreis ist in der Zeichnung nicht näher dargestellt).

Das Verdampfergefäß 34 ist mit Hilfe von Winkelstücken 53, 53' zwischen den beiden Platinen 3, 4 gehalten, und zwar so, daß die Strahlrichtung der Düse 36 gegen die zu beschichtende Seite des Bandes bzw. der Folie 50 ausgerichtet ist.

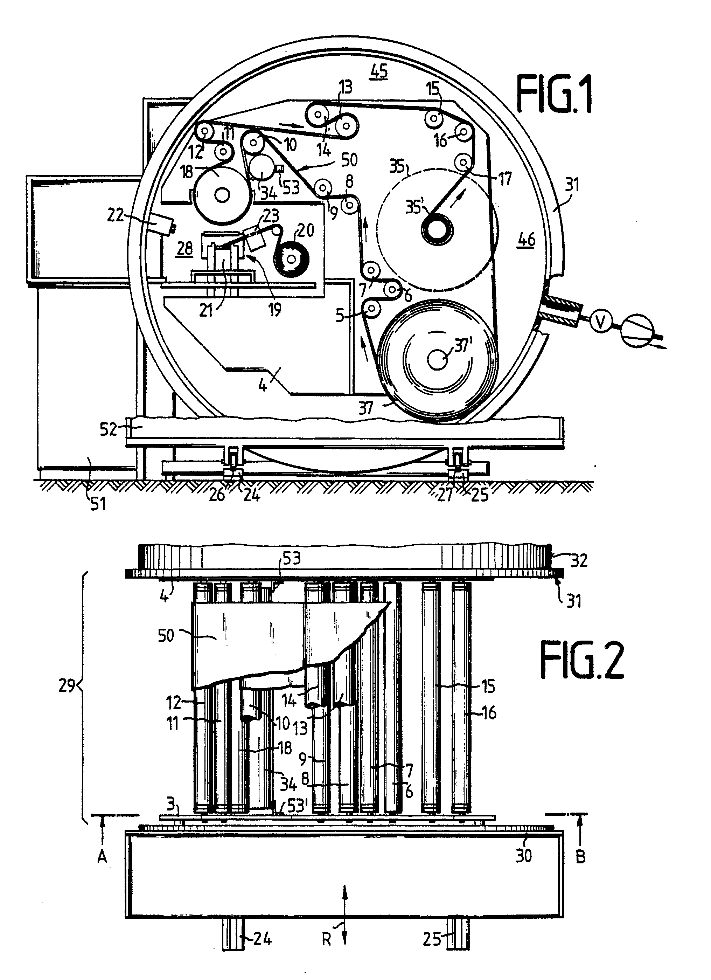

Wie Figur 2 zeigt, ist die Düse 36 an einem Abschnitt der Wickelbahn angeordnet, der sich zwischen der Umlenkrolle 10 und der Beschichtungswalze 18 befindet, so daß unmittelbar nach dem Benetzen der durchlaufenden Folie 50 mit dem Trennmittel der eigentliche Beschichtungsprozeß erfolgt. Es ist klar, daß die Partien der Folie 50, die vom Trennmittel (beispielsweise einem Silikonöl) benetzt worden sind, sich das im Verdampfungsschiffchen 21 verdampfte Metall nicht niederschlagen kann, so daß es von der Zahl der Düsen 36, die nebeneinanderliegend über die Länge des Gefäßes 34 verteilt angeordnet sind, abhängt, wie viele Partien der Seitenfläche der Folienbahn 50 unbedampft bzw. unbeschichtet bleiben.

Bei der in den Figuren 1 und 2 dargestellten Vorrichtung sind die Walzen 5 bis 17 zum Transport und zur Führung der Folienbahn 50 so angeordnet, daß die Partie der Folienbahn 50, die sich unmittelbar vor der Beschichtungswalze 18 befindet, in einem steilen Winkel, d. h. nahezu lotrecht von der Walze 10 aus nach unten läuft. Es ist klar, daß diese Partie der Folienbahn 50 auch anders geführt werden kann, beispielsweise in einer etwa horizontalen Ebene auf die Beschichtungswalze 18 auflaufen kann, ohne daß der in Figur 3 näher dargestellte Verdampfer 34 in seiner Konstruktion geändert werden muß.


Auflistung der Einzelteile


3 Platine
4 Platine
5 Umlenkrolle
6 Spannrolle
7 Umlenkrolle
8 Umlenkrolle
9 Breitstreckrolle
10 Umlenkrolle
11 Zugmeßrolle
12 Zugrolle
13 Meßwalze
14 Umlenkrolle
15 Breitstreckrolle
16 Zugmeßrolle
17 Umlenkrolle
18 gekühlte Beschichtungswalze
19 Verdampfungsquelle
20 Aluminiumdrahtspule
21 Verdampfungsschiffchen
22 Fernsehkamera
23 Drahtzuführung
24 Laufschiene
25 Laufschiene
26 Rolle
27 Rolle
28 Beschichtungskammer
29 Wickeleinrichtung
30 Deckel
31 Stirnfläche
32 Hohlzylinder, Gehäuse

33 Trennmittel, Öl
34 Gefäß, Verdampfergefäß
35 Aufwickel
35' Aufwickelrolle
36 Düse
37 Abwickel
37' Abwickelrolle
39 Dampfaustrittsrohr
40 Raum
42 Oberfläche des Trennmittelbades
43 Heizelement
44 Düsenkopf
45 Kammer
46 Badspiegel
47 Temperaturfühler
50 Wickelbahn, Band, Folienbahn
51 Schaltschrank
52 Stützgestell
53 Winkelstück
53' Winkelstück

## Ansprüche

1. Vorrichtung zum Herstellen von metallfreien Streifen bei im Vakuum beschichteten Folienbahnen, insbesondere für Kondensatoren, bestehend aus einem Gehäuse (32), mit einem Deckel (30) zum druckdichten Verschließen des Gehäuses und einer Wickeleinrichtung (29), mit zwischen Platinen (3, 4) drehbar gelagerten Umlenk- und Spannrollen (5 bis 17), mindestens einer Beschichtungsrolle (18) und einer Aufwickel- und Abwickelrolle (35', 37') sowie einer im Gehäuse (32) gehaltenen Beschichtungsquelle (19) und mit einem quer zur Laufrichtung der Wickelbahn (50) angeordneten, vorzugsweise rohrförmigen Gefäß (34) zur Aufnahme von einem verdampfbaren Trennmittel (33), beispielsweise von einem Öl, mit mindestens einer Düse (36) für den Austritt des zu verdampfenden Trennmittels (33) aus dem Gefäß (34) auf die in unmittelbarer Nachbarschaft der Austrittsdüse (36) vorbeilaufende Folienbahn (50), **dadurch gekennzeichnet,** daß das zumindest teilweise mit einem verdampfbaren Trennmittelvorrat (33) gefüllte Gefäß (34) mit mindestens einem Dampfaustrittsrohr (39) versehen ist, dessen Austrittsdüse (36) unterhalb des Oberflächenniveaus (46) des Trennmittelvorrats (33) in die Beschichtungskammer (45) in unmittelbarer Nähe der zu beschichtenden Folienbahn (50) mündet, wobei das der Düse (36) abgekehrte Ende des Dampfaustrittsrohrs (39) im Raum (40) des Gefäßes (34) oberhalb des Trennmittelvorrats (33) endet.

2. Vorrichtung nach Anspruch 1, **dadurch gekennzeichnet,** daß in die untere Partie des rohrförmigen, etwa horizontal gehaltenen Gefäßes (34) ein Düsenkopf (44) eingeschraubt oder mit diesem verschweißt, verlötet oder vernietet ist, dessen Austrittsdüse (36) radial nach außen geführt ist und mit dem das Dampfaustrittsrohr (39) fest verbunden ist, dessen oberes Ende (39') oberhalb des Badspiegels (46) im Raum (40) des Gefäßes (34) endet, wobei eine Heizpatrone (43) im unteren Teil des Gefäßinnenraums in der Nachbarschaft des Düsenkopfes (44) gehalten ist, die den Düsenkopf (44) während des Verdampfungsvorgangs auf einer Soll-Temperatur hält.

3. Vorrichtung nach den Ansprüchen 1 und 2, **dadurch gekennzeichnet,** daß das Dampfaustrittsrohr (39) in einem flachen Winkel gebogen ausgebildet ist, wobei der obere Abschnitt des Rohres (39) eine etwa lotrechte Stellung aufweist und der untere Abschnitt des Rohres (39) seitlich bei etwa waagrecht angeordnetem Gefäß (34), jedoch unterhalb des Badspiegels (46) in den Düsenkopf (44) einmündet.

FIG.1

FIG.2

# FIG.3

Patentamt

**EUROPÄISCHER RECHERCHENBERICHT**

Nummer der Anmeldung

EP 90111852.1

## EINSCHLÄGIGE DOKUMENTE

| Kategorie | Kennzeichnung des Dokuments mit Angabe soweit erforderlich der maßgeblichen Teile | Betrifft Anspruch | KLASSIFIKATION DER ANMELDUNG (Int Cl5) |
|---|---|---|---|
| D,A | DE - C2 - 3 224 234 <br>(SIEMENS AG)<br> * Ansprüche 1-6 * | 1 | C 23 C 14/04<br>C 23 C 14/56 |
| A | DE - A1 - 3 726 113 <br>(LEYBOLD AG)<br> * Anspruch 1; Fig. 1,2 * | 1 | |
| A | DE - A1 - 3 615 487 <br>(SCHMOOCK, HELMUTH)<br> * Anspruch 1 * | 1 | |
| A | DE - A1 - 3 738 722 <br>(LEYBOLD AG)<br> * Spalte 1, Zeilen 1-13 * | 1 | |

RECHERCHIERTE
SACHGEBIETE (Int Cl5)

C 23 C

Der vorliegende Recherchenbericht wurde für alle Patentansprüche erstellt.

| Recherchenort | Abschlußdatum der Recherche | Prüfer |
|---|---|---|
| WIEN | 28-09-1990 | SEIRAFI |